(19)

Europäisches
Patentamt
European
Patent Office
Office européen
des brevets

(11)     **EP 3 007 234 A1**

(12)                    **EUROPEAN PATENT APPLICATION**

(43) Date of publication:
**13.04.2016  Bulletin 2016/15**

(51) Int Cl.:
**H01L 31/04** (2006.01)        **H02J 3/38** (2006.01)

(21) Application number: **14188058.3**

(22) Date of filing: **08.10.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ABB Technology AG**
**8050 Zürich (CH)**

(72) Inventor: **Dominguez, Luis**
**Brugg 5200 (CH)**

(74) Representative: **ABB Patent Attorneys**
**C/o ABB Schweiz AG**
**Intellectual Property (CH-LC/IP)**
**Brown Boveri Strasse 6**
**5400 Baden (CH)**

(54)     **Operation of large scale PV plants**

(57)     The present invention is concerned with large-scale photovoltaic (PV) plants subject to non-uniform solar irradiance and/or partial shading. According to the invention, a mathematical model of a PV generator (1) with a plurality of PV modules (4) as basic components arranged in strings (3) and electrically connected to an inverter (6) is built. A lay-out model comprises component dimension and PV generator configuration data. The PV generator model is used in conjunction with solar irradiance and temperature forecasts, derived from advanced sensors or forecasting systems, to describe the electrical properties of the PV generator. Quantities that may be determined or predicted include a Maximum Power Point (MPP) or the voltage region in which such point may be located, output power, ramp rate, maximum power drop, and duration of intermittency.

**Fig. 3**

**Description**

FIELD OF THE INVENTION

The invention relates to large-scale distributed photovoltaic plants, specifically to their operation under non-uniform irradiation.

BACKGROUND OF THE INVENTION

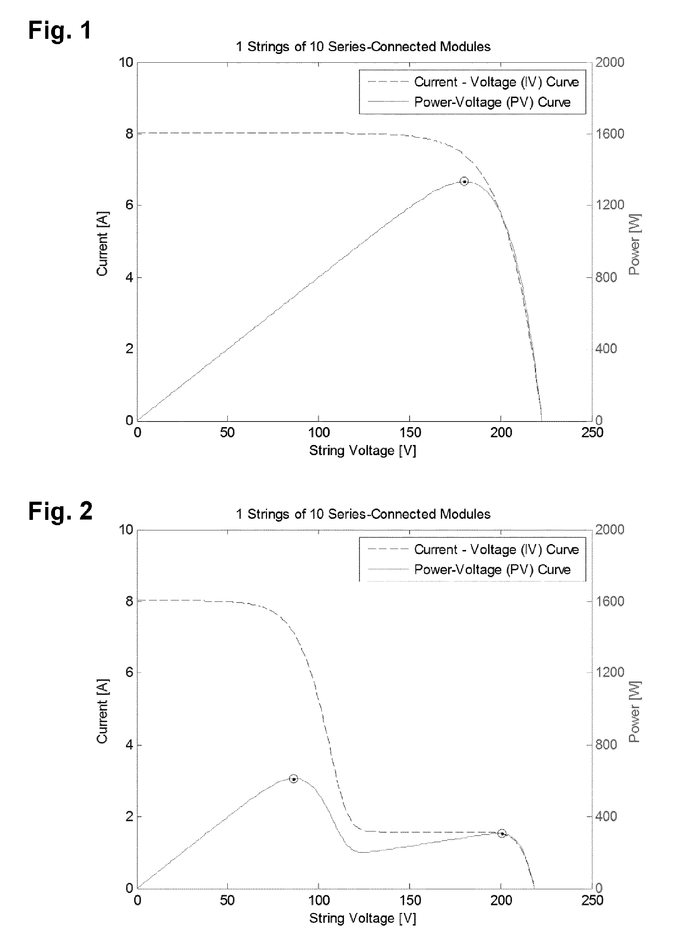

Conventional Maximum Power Point (MPP) tracking algorithms may fail to provide the global MPP if a large scale distributed photovoltaic power plant is subject to non-uniform irradiation and/or partial shading conditions. This situation often arises when passing clouds occlude the sun and cast a shadow over the modules of a photovoltaic (PV) generator. In an exemplary case of a PV generator consisting of a single string of ten series-connected identical modules, characteristic curves in the absence of any shading are shaped as depicted in Fig.1. The characteristic curves include the IV curve - the relation between current (I) and voltage (V), and the PV curve - the relation between power (P) and voltage of the PV generator. The PV curve is unimodal and presents a single MPP corresponding to pMPP = 1333 W obtained at a voltage vMPP = 180 V and current iMPP = 7.41 A. In this case, several basic MPP tracking algorithms may be able to identify the MPP efficiently.

The two characteristic curves in Fig.1 are representative of a superposition, corresponding to the electrical series connection of the modules, of characteristic curves of the individual modules. These single-module curves have a similar shape as the resulting curves in Fig.1 but are scaled to a voltage vMPP of only around 20 V. At a different ambient temperature, under partial shading conditions, and/or subject to lower irradiance due to the position of the sun, the single-module characteristic curve still exhibits a shape as in Fig.1, but with vMPP and iMPP being further reduced. Accordingly, in a partial shading scenario where the last three of the string modules are shadowed, the characteristic curves of the string may change to those shown in Fig.2. The characteristic shape with a distinguished drop in current results from a superposition of ten single-module curves of at least two distinct shapes corresponding to high and low irradiance. In this case, the PV characteristic curve presents two local MPPs, one at the voltage vMPP_1 = 86 Volts and the other one at the voltage vMPP_2 = 201 Volts. Clearly, the global MPP is given by the low voltage case, which however may be difficult to detect for a conventional MPP tracking algorithm implemented in the inverter.

In patent application US 20130257155 the solar cells are mounted in groups in a rotatable manner such that depending on the time of day and / or orientation of the groups, self-shading may occur. In order to avoid local MPPs an MPP tracking module is configured to detect self-shading via information including motor set points of a solar tracker responsible for positioning the solar cells. In a modified method the MPP is identified by performing a current-voltage curve sweep with a sequence of decrementing inverter reference voltage set points with increasing step size.

The patent application US 20100198420 discloses tracking a movement of clouds to predict the effects of cloud cover on irradiation of a solar-powered distributed power generation system. A determination is made whether predicted effects of incoming changes on power output are within tolerable limits. A predicted electrical power output, or output change, is used to operate the solar-powered system, specifically the inverters connected to interconnected photovoltaic modules. The actuation possibilities of the inverters, including intentionally operating an inverter off a Maximum Power Point (MPP), may then be utilized to produce electrical power below a maximum power, and thus smoothen ramp rates in the power system. Alternatively, predicted electrical power output information can be used to coordinate the operation of energy storage systems or the output of other co-located power storage or generating means such as batteries or diesel engines to smoothen the total power output at a certain node.

The patent application EP 14150332.6 likewise discloses operation of photovoltaic plants based on short-term forecasting of solar irradiance on the absorbing elements of the plant. It involves recursive updating of estimated parameters pertaining to pre-defined and physically motivated cloud evolution models that are instantiated and assigned to clouds identified in images taken by a ground-based visible-light camera. Identification of clouds, which includes assigning individual pixels of an image to one or several identified clouds, and selection of matching cloud models ultimately allows to predict a cloud-wise, as opposed to a pixel-wise, evolution based on cloud evolution models with a limited number of estimated parameters.

DESCRIPTION OF THE INVENTION

It is an objective of the invention to improve controllability of large-scale photovoltaic plants under non-uniform solar irradiance and/or partial shading, and in particular to maximize the energy that can be extracted from a photovoltaic generator under such conditions. This objective is achieved by a method and a device according to the independent claims. Preferred embodiments are evident from the dependent patent claims.

According to the invention, a mathematical model of a photovoltaic (PV) generator is built, in which PV modules and diodes form the basic components, and of which a lay-out model comprises component dimension and PV generator configuration data. The PV generator model is used in conjunction with solar irradiance and temperature forecasts, derived from advanced sensors or forecasting systems, to describe the electrical properties of the PV generator. Quantities that may be determined or predicted include a Maximum Power Point (MPP) or the voltage region in which such point may be located, output power, ramp rate, maximum power drop, and duration of intermittency.

Specifically, operating a PV generator with a plurality of PV modules arranged in strings and electrically connected to an inverter in a large-scale PV plant subject to non-uniform solar irradiance and/or partial shading comprises the steps of

- defining, or composing, a PV generator model of the PV generator based on static PV generator lay-out electrical and geometrical topology data and based on characteristic current-voltage (IV) curves describing, or representing, an irradiation and temperature dependent electrical performance, or property, of the modules,
- providing, preferably forecasting, for each module an irradiation and temperature level, possibly relative to standard conditions, and
- determining, from the PV generator model and the irradiation and temperature levels, a characteristic IV curve of the entire PV generator.

In a preferred variant of the invention, an equivalent circuit model of the PV modules incorporates a module bypass diode representative of intra-module diodes, and the characteristic IV curves of the modules represent module performance under consideration of a module bypass diode current.

In an advantageous embodiment of the invention, a PV controller determines a global MPP of the characteristic curve of the PV generator by solving a global optimization problem, and provides the MPP, or a region comprising the MPP, to an inverter controller of the inverter. This allows real-time power output maximization based on actual ambient conditions, and with minimized disturbances due to voltage sweeping by the inverter controller.

In another advantageous embodiment of the invention the PV generator is connected to a DC bus in parallel with an energy storage such as a battery. A PV power output set point of the PV generator is determined or decided first, and an operation of the energy storage is then controlled in order to maintain a voltage of the DC bus, or a power ramp of DC bus power being jointly generated by the PV generator and provided or absorbed by the energy storage, within limits. Preferably, a PV output power forecast of the PV generator is determined based on short-term forecasting of solar irradiance on the PV generator, and used by an energy storage management system to mitigate power ramps predicted.

In another advantageous embodiment of the invention the inverter is deliberately operated at a voltage different from a voltage of a global MPP. Specifically, during positive ramps, the PV generator is constrained to a maximum allowable power to be supplied by the inverter, and the PV controller may, to that end, curtail power by adjusting the PV generator voltage to appropriate, non-optimum levels. Preferably, a PV output power forecast of the PV generator is determined based on short-term forecasting of solar irradiance on the PV generator, and used by the PV controller to mitigate power ramps predicted. In anticipation of forecast negative power ramps, the power of the inverter may even be curtailed proactively so as to comply with the ramp rate limits.

The present invention also relates to a computer program product including computer program code for controlling one or more processors of a device adapted to control a PV generator based on a model of the PV generator, particularly, a computer program product including a computer readable medium containing therein the computer program code.

BRIEF DESCRIPTION OF THE DRAWINGS

The subject matter of the invention will be explained in more detail in the following text with reference to preferred exemplary embodiments which are illustrated in the attached drawings, in which:

> Fig.1 shows the characteristic curves of a string of 10 PV modules uniformly irradiated;
> Fig.2 shows the characteristic curves of a string of 10 PV modules partially shaded;
> Fig.3 depicts the structure of an exemplary distributed photovoltaic generator;
> Fig.4 depicts a photovoltaic generator with module bypass diodes and control elements;
> Fig.5 depicts a photovoltaic generator supported by an energy storage unit;
> Fig.6 is an equivalent electrical circuit model of a single PV module; and
> Fig.7 is a simulated evolution of power-voltage characteristic curves of a PV generator.

In principle, identical parts are provided with the same reference symbols in the figures.

DETAILED DESCRIPTION OF PREFERRED EMBODIMENTS

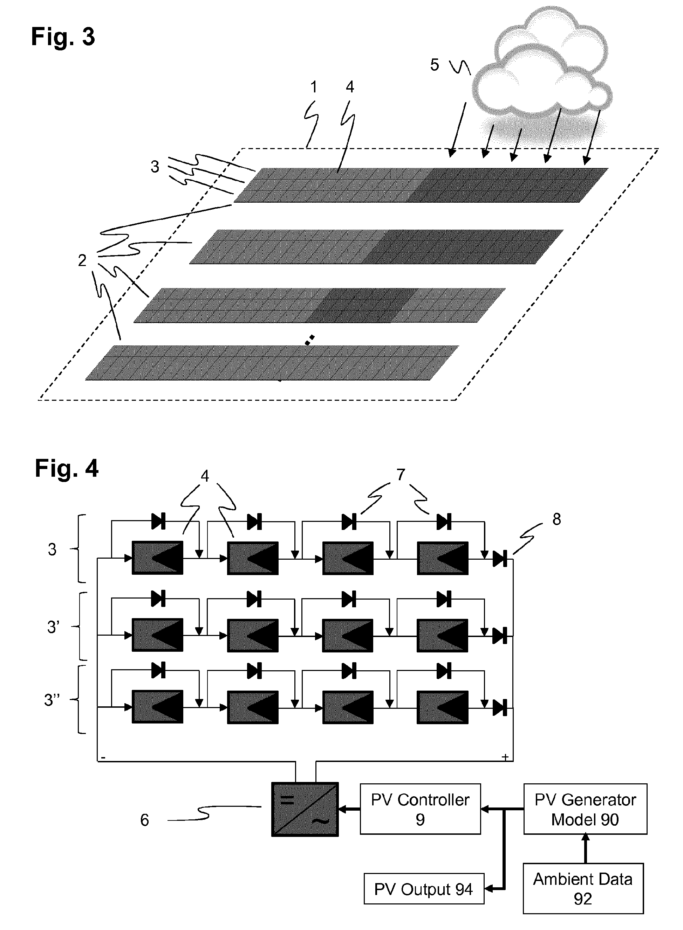

Fig.3 schematically depicts the structure of an exemplary distributed photovoltaic (PV) generator 1 with four arrays 2, each array comprising three strings 3, and each string comprising 24 modules 4. A passing cloud 5 shadows the top-right corner of the PV generator as indicated by the darker shading of some of the modules. The modules have an active surface area in the order of one to twenty square meters and in turn comprise a number of PV cells. The nominal assignment of the distributed modules to well-defined strings and arrays is optional, and may include any number of modules per string, of strings per array, and of arrays per PV generator. Other groupings of modules may be termed panels, and/or may be mounted rotatable around some axis in order to orient the modules towards the sun for optimum solar illumination. The electrical connection of the cells in the module, and of the modules within the PV generator, may include series, total-cross-tied, bridge-linked, or any other state-of-the-art connection. All the modules of the PV generator are electrically connected to a single inverter converting direct current (DC) generated by the PV cells to alternating current (AC). The AC-side of the inverter is connected to an AC-grid or bus. Additional distributed PV generators of the kind depicted in Fig.3 and each including a dedicated inverter connected to the AC-grid or bus may be present in a large scale PV plant.

Fig.4 depicts a PV generator with three strings 3, 3', 3" connected in parallel to a DC/AC inverter 6, wherein each string includes four PV modules 4 connected in series. Each module in turn is equipped with a module bypass diode 7 as a consolidated or agglomerated equivalent of cell bypass diodes of the PV cells in the module. Each string is protected against current reversal in its entirety by a string blocking diode 8. The inverter is controlled by a PV controller 9 based on a PV generator model 90 of the PV generator. The PV generator model is based on static PV lay-out model data including module specifications and plant topological information, both electrical and geometrical such as configuration, arrangement, and separating distances between modules, strings and arrays. The PV generator module receives ambient data 92 including irradiance and temperature data at a present or future point in time, and is likewise capable of determining PV output data 94 indicative of a present or future power output by the PV generator at a certain operating point.

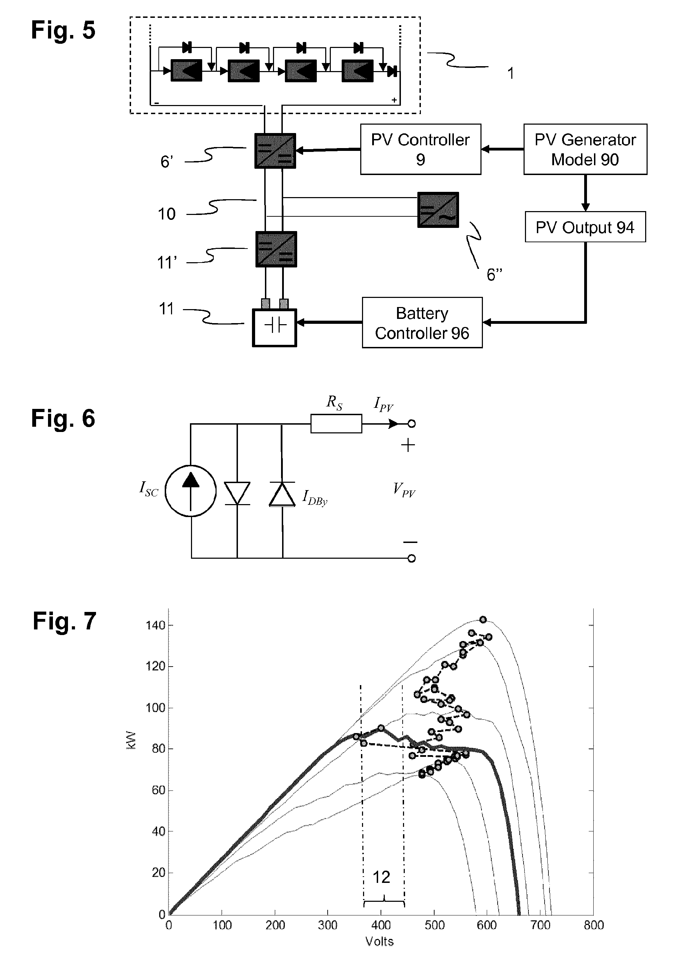

Fig.5 depicts a PV generator 1 connected to a DC/DC inverter 6' generating a DC bus voltage on a DC bus 10 that is likewise fed from a battery 11, or any other kind of energy storage, via battery inverter 11'. DC/AC inverter 6" inverts the DC current of the DC bus to AC current for use in a connecting AC grid. Battery control unit 96 is receiving PV generator model based PV power output data in order to support the DC voltage, or a ramp rate thereof, by transferring power between the DC bus and the battery.

The ambient data 92 includes solar irradiation and temperature data for the PV plant. Irradiation data may be obtained from cloud tracking systems that employ satellite or ground based visible-light imagery to monitor sky conditions, or through a network of irradiance sensors or pyranometers dispersed across the area of the PV plant. The ambient data may include real-time observations on a level of grid points or regions covering the plant area. The ambient data may also include forecast ambient data on a plant level, presented for example as a time series. Such irradiation and temperature forecasts in conjunction with the plant lay out may be evaluated to provide local predictive information including the estimated shaded sections of the PV plant and the number and/or locations of shaded modules, strings and arrays. Specifically, time-series data of irradiation G and temperature T, either in absolute values or relative to the standard test conditions of 1000 W/m$^2$ and 25°C, may be provided for each module.

The PV generator model 90 of the PV generator may be ultimately based on a physical model of a photovoltaic cell (Shockley diode model), suitably multiplied and aggregated to describe an entire photovoltaic module as a collection of cells interconnected in a specific manner. Alternatively, choosing an empirical model of an entire module considerably simplifies the process. The parameters required for such a modelling of the electrical performance or properties of a PV module may be extracted from the specification data sheet provided by the module manufacturer, at least at standard operating conditions. Exemplary electrical parameters include open circuit voltage $V_{OC}$, short circuit current $I_{SC}$, voltage vMPP and current iMPP defining a maximum power point, which parameters together determine the scaling of a characteristic IV-curve of the module similar to the IV curve depicted in Fig.1. Thermal characteristics of the module such as temperature coefficients in order to account for thermal effects may also be extracted from the specification data sheet.

Fig.6 depicts a circuit diagram representing the main parameters of a model of a single PV module. The circuit includes a photo-current source, a series resistance, and an optional diode bypass or junction in parallel to the photo-current source. Of the aforementioned parameters of the characteristic curve of the module the open circuit voltage $V_{OC}$ is the voltage $V_{PV}$ at the terminals of the module at zero current ($I_{PV}$=0) while the short circuit current $I_{SC}$ is the current $I_{PV}$ through the terminals at zero voltage drop ($V_{PV}$=0).

The model of the PV module may account for cell bypass diodes that are integrated inside the modules to mitigate adverse polarization effects, or current reversal, caused by non-uniform irradiation and/or partial shading conditions. Bypass diodes are installed in antiparallel after a sequence of series connected PV cells in order to bypass shaded cells that present low short-circuit currents, and prevent damage to the photovoltaic module caused by the formation of hot spots. The effect of the bypass diodes is thus a reduction in the output voltage of the module. Parameters such as forward voltage and on-resistance, required for accurate modelling of the bypass diodes may be extracted from manufacturer data sheets. However, for the purpose of simplifying the modelling effort it is convenient to consider a single bypass diode for the entire module as a consolidated or agglomerated equivalent of the cell bypass diodes, to account for the effects of the bypassed cells.

With the thermal voltage $V_t$, and the bypass diode current $I_{DBy}$ the above model of a single module leads to the following exemplary non-analytical relation:

$$I_{PV} = I_{sc} - I_{sc}e^{\frac{(V_{PV}-V_{oc}+I_{PV}Rs)}{V_t}} + I_{DBy}$$

$$I_{DBy} = I_{DBy,sat}e^{\left(-\frac{V_{PV}}{mV_t}-1\right)}$$

Further explanations as well as details about the empirical modelling of the irradiation and temperature scaling, or dependence, of the aforementioned parameters of the characteristic curves may be found in a paper by L. F. Dominguez, entitled "Modelling and Simulation of Utility-scale PV Plants under Partial Shading Conditions", 4th Solar Integration Workshop, Berlin, Germany, November 10-11, 2014. The PV module model may be then expanded to construct a larger model describing a string as a series connection of modules, optionally including a string blocking diode as well, while a string model may be further extended to describe an array or set of arrays which are subsequently connected to a junction box or directly feeding an inverter.

Fig.7 depicts a simulated evolution of power-voltage characteristic curves of a PV generator caused by partial shading from clouds moving between the sun and the PV generator. The five thin lines are selected power-voltage curves at certain points in time during a partial shading scenario while the thick line represents the currently latest point in time. The dots interconnected by a broken line represent the global MPP tracked by the PV controller for a large number of points in time (for which the individual power-voltage curves have been omitted for sake of legibility). As apparent, in between the rather smooth curves at little or no shading some heavily distorted power-voltage curves are generated which exhibit multiple local maximum power points. In particular, the global MPP of the latest curve is located at around 400 V, which is distinctly lower than the voltage (600 V) of the local MPP that a tracking algorithm based on decrementing inverter reference voltage set points may detect first.

The global MPP of the characteristic curves depicted in Fig.7 may be identified in an optimization problem for a maximum power output of the PV generator including ab objective function based on the PV generator model. Under uniform irradiation, this problem corresponds to a nonlinear programming problem (NLP) which may be solved using standard optimization solvers. Under non-uniform irradiation or partial shading conditions, however, this problem becomes a non-convex optimization problem for some of the modules operating at different conditions of irradiation and temperature, which results in the formation of various local MPPs in the power-voltage characteristics. Global optimization techniques are thus required such as branch and bound (B&B) or branch and reduced (B&R) in combination with local solvers. In order to reduce the computational effort/time for finding a solution, a use of linearization techniques, active set or parametric optimization strategies, as well as the use of parallel computation in conjunction of multi-core platforms may be advisable.

The PV controller 9 for operating the inverter of the PV generator is responsible for identifying the optimal voltage level or for at least approximating a region 12 which maximizes the energy output of the PV generator. This information may then be passed to an inverter controller of the inverter. Specifically, the PV controller could provide a voltage set point or move the inverter MPP tracking algorithm to a region 12 around the global MPP where to sweep the voltage in order to arrive faster to the global maximum power point. This strategy minimizes the disturbance to the system by reducing the amount of voltage sweeping thus reducing current rippling which may be transferred to the AC side of the inverter.

If the control algorithms embedded in the inverter controller do not accept this kind of external input, the output of the PV controller may at least be used to monitor the performance of the inverter under partial shading conditions. If this monitoring should indicate that the power extracted is not corresponding to the global MPP, appropriate corrective action may be applied in a subsequent stage.

The battery controller 96 may be derived from a mathematical model of the battery or energy storage system. Such model may be deterministic, stochastic or empirical and should take into account several performance measures such as state of charge (SOC) and state of health (SOH) and rate of charge and discharge of the system.

After a period the generator model may not be able to predict the correct performance of the generator due to external conditions such as the degradation of its components, increase in thermal and electrical losses, and/or accumulation of dirt, snow or any other external element over the module surface. In this case, a parameter identification function block may be utilized to update the parameters of the model using information from available sensor measurements.

While the invention has been described in detail in the drawings and foregoing description, such description is to be considered illustrative or exemplary and not restrictive. Variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. The mere fact that certain elements or steps are recited in distinct claims does not indicate that a combination of these elements or steps cannot be used to advantage, specifically, in addition to the actual claim dependency, any further meaningful claim combination shall be considered disclosed.

## Claims

1. A method of operating a photovoltaic PV generator (1) with a plurality of modules (4) connected to an inverter (6), comprising

   - defining a PV generator model of the PV generator based on PV generator lay-out data and based on characteristic curves describing an irradiation-dependent and temperature-dependant electrical performance of the modules,
   - providing, for each module, an irradiation and temperature level, and
   - determining, from the PV generator model and the irradiation and temperature levels, a characteristic curve of the PV generator.

2. The method of claim 1, wherein the characteristic curves of the modules represent module performance under consideration of a module bypass diode current $I_{DBy}$.

3. The method of claim 1 or 2, comprising

   - determining a global Maximum Power Point (MPP) of the PV generator, and
   - providing the MPP, or a region (12) including the MPP, to the inverter.

4. The method of claim 1 or 2, wherein providing an irradiation level for each module is based on short-term forecasting of solar irradiance on the PV generator.

5. The method of claim 3 or 4, wherein the PV generator is connected to an energy storage (11), comprising

   - determining a PV output power of the PV generator, and
   - determining an operation of the energy storage based on the PV output power.

6. The method of claim 3 or 4, comprising

   - determining a voltage vMPP of a global MPP of the PV generator, and
   - operating the inverter at a voltage different from the voltage vMPP of the global MPP.

7. A controller for operating a photovoltaic PV generator (1) with a plurality of modules (4) connected to an inverter (6), configured to determine a global MPP of the PV generator by solving an optimization problem including an objective function involving a PV generator model of the PV generator, wherein the PV generator model is based on PV generator lay-out data and based on characteristic curves describing an irradiation-dependent and temperature-dependent electrical performance of the modules, and wherein the objective function is based on irradiation levels provided for each module.

## Fig. 1

1 Strings of 10 Series-Connected Modules

Legend:
- Current - Voltage (IV) Curve
- Power-Voltage (PV) Curve

X-axis: String Voltage [V]
Left Y-axis: Current [A]
Right Y-axis: Power [W]

## Fig. 2

1 Strings of 10 Series-Connected Modules

Legend:
- Current - Voltage (IV) Curve
- Power-Voltage (PV) Curve

X-axis: String Voltage [V]
Left Y-axis: Current [A]
Right Y-axis: Power [W]

# Fig. 3

# Fig. 4

**Fig. 5**

**Fig. 6**

**Fig. 7**

Europäisches
Patentamt

European
Patent Office

Office européen
des brevets

# EUROPEAN SEARCH REPORT

Application Number

EP 14 18 8058

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2014 022686 A (SONY CORP) 3 February 2014 (2014-02-03) * the whole document * ----- | 1,7 | INV. H01L31/04 H02J3/38 |
| X | US 2011/276269 A1 (HUMMEL STEVEN G [US]) 10 November 2011 (2011-11-10) * the whole document * ----- | 1-7 | |
| A | US 2014/028104 A1 (MAKOVER AMIR [IL] ET AL) 30 January 2014 (2014-01-30) * the whole document * ----- | 2 | |
| A | JP 2012 028435 A (HITACHI LTD) 9 February 2012 (2012-02-09) * the whole document * ----- | 2 | |

TECHNICAL FIELDS
SEARCHED      (IPC)

H01L
H02J

The present search report has been drawn up for all claims

| Place of search | Date of completion of the search | Examiner |
|---|---|---|
| Munich | 19 December 2014 | Martin, Raynald |

EPO FORM 1503 03.82 (P04C01)

**EP 3 007 234 A1**

## ANNEX TO THE EUROPEAN SEARCH REPORT
## ON EUROPEAN PATENT APPLICATION NO.

EP 14 18 8058

This annex lists the patent family members relating to the patent documents cited in  the above-mentioned European search report.
The members are as contained in the European Patent Office EDP file on
The European Patent Office is in no way liable for these particulars which are merely given for the purpose of information.

19-12-2014

| Patent document cited in search report | | Publication date | Patent family member(s) | | Publication date |
|---|---|---|---|---|---|
| JP 2014022686 | A | 03-02-2014 | NONE | | |
| US 2011276269 | A1 | 10-11-2011 | CA | 2798825 A1 | 10-11-2011 |
| | | | CA | 2798827 A1 | 10-11-2011 |
| | | | JP | 2013526824 A | 24-06-2013 |
| | | | JP | 2013529051 A | 11-07-2013 |
| | | | US | 2011276269 A1 | 10-11-2011 |
| | | | US | 2011282514 A1 | 17-11-2011 |
| | | | WO | 2011140553 A1 | 10-11-2011 |
| | | | WO | 2011140565 A1 | 10-11-2011 |
| US 2014028104 | A1 | 30-01-2014 | US | 2014028104 A1 | 30-01-2014 |
| | | | WO | 2012107919 A1 | 16-08-2012 |
| JP 2012028435 | A | 09-02-2012 | NONE | | |

EPO FORM P0459

For more details about this annex : see Official Journal of the European Patent Office, No. 12/82

EP 3 007 234 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20130257155 A
- US 20100198420 A
- EP 14150332 A

**Non-patent literature cited in the description**

- **L. F. DOMINGUEZ.** Modelling and Simulation of Utility-scale PV Plants under Partial Shading Conditions. *4th Solar Integration Workshop, Berlin, Germany,* 10 November 2014